(19) Europäisches Patentamt
European Patent Office
Office européen des brevets

(11) **EP 2 357 270 B1**

(12) **EUROPÄISCHE PATENTSCHRIFT**

(45) Veröffentlichungstag und Bekanntmachung des Hinweises auf die Patenterteilung:
**06.06.2012 Patentblatt 2012/23**

(51) Int Cl.:
*C25D 21/18* *(2006.01)*          *C25D 17/02* *(2006.01)*
*C23C 18/16* *(2006.01)*          *C25D 21/12* *(2006.01)*
*C25D 21/14* *(2006.01)*

(21) Anmeldenummer: **11150790.1**

(22) Anmeldetag: **13.01.2011**

(54) **Bleed-und-Feed-Vorrichtung und -Verfahren**

Bleed and feed device and method

Procédé et dispositif pour tirer et alimenter

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.01.2010 DE 102010004966**

(43) Veröffentlichungstag der Anmeldung:
**17.08.2011 Patentblatt 2011/33**

(73) Patentinhaber: **Ancosys GmbH**
**72124 Pliezhausen (DE)**

(72) Erfinder: **Stahl, Jürg**
**8400 Winterthur (CH)**

(74) Vertreter: **Mammel, Ulrike et al**
**Mammel & Maser**
**Patentanwälte**
**Tilsiter Strasse 3**
**71065 Sindelfingen (DE)**

(56) Entgegenhaltungen:
**WO-A2-2007/114900     US-A1- 2004 142 566**
**US-A1- 2005 133 374     US-A1- 2006 144 712**
**US-B1- 6 524 642**

**Beschreibung**

Bleed-und-Feed-Vorrichtungen und -Verfahren kommen in vielen chemischen Produktionsprozessen wie beispielsweise der Halbleiterherstellung zur Anwendung.

Ziel dieser Art des Nachdosierens ist es, konstante Konzentrationen der einzelnen Substanzen in einem Gemisch oder Bad während der produktion über einen längeren Zeitraum zu erreichen. Mit dieser Betriebsart ist es ebenfalls möglich, auch Stoffe, die sich während der Benutzungsdauer aufkumulieren würden, über die Verdünnung konstant zu halten.

Dies wird üblicherweise mit einer "Feed"-Lösung erreicht, die eine höhere Konzentration aufweist als die Sollkonzentration und nur die Stoffe beinhaltet, die verbraucht werden. Die Zugabe der feed-Lösung, d.h. der Einspeiselösung, wird meistens in belastungsabhängigen Zeitintervallen mit konstanten Volumina vorgenommen. Zum Beispiel wird einmal pro Tag zwischen 5% und 30% des gesamten Badvolumens ausgetauscht.

Das "Bleed", d.h. die Entnahme, erfolgt über einen passiven Überlauf am Tank oder über eine Pumpe, die über einen Minimum-Maximum-Sensor gesteuert wird. Abbauprodukte, die während des Produktionsprozesses entstehen, werden auf diese Art regelmäßig verdünnt und können über einen längeren Zeitraum unter einer kritischen Konzentration gehalten werden.

Dieses Konzept der Prozessführung hat mehrere Nachteile, speziell bei Prozessen, die eine hohe Anforderung an die Konstanz der Konzentration der einzelnen Substanzen im Gemisch stellen wie beispielsweise der Halbleitertechnologie. Bedingt durch die Zuführung in Zeitintervallen kommt es systembedingt zu einem sägezahnförmigen Verlauf der Konzentrationen im Gemisch. Auch muss der Produktionsprozess zum Zeitpunkt der Zuführung teilweise ausgesetzt werden, da das Volumen und die Konzentrationen im Tank in Abhängigkeit von den Produkten, die sich im Tank oder in der Prozesskammer befinden, schwankt. Zudem unterliegen angelieferte Feed-Lösungen fertigungsbedingten Konzentrationsschwankungen. All diese Schwankungen führen bei anspruchsvollen Prozessen zu variierenden Ergebnissen bei den produzierten Produkten und im schlimmsten Fall zu Ausschuss oder Ausfällen in der Anwendung des herzustellenden Produktes. Außerdem ist die Forderung, dass in der Feed-Lösung nur Substanzen, die verbraucht werden, vorhanden sind, in der Praxis nur schwer zu erfüllen.

In der US-Patentanmeldung 2004/0142566 A1 wird vorgeschlagen, eine geringere Menge des bades in kürzeren Zeitintervallen auszutauschen, so dass das gesamte gewünschte Nachfüllen über eine Zeitdauer von 24 Stunden auf graduelle Weise erreicht wird. Bei diesem Verfahren wird die typische Intervallzeit von 24 Stunden auf 30 - 60 Minuten reduziert. Bei dem aus dieser US-Anmeldung bekannten Verfahren wird Bleed-Lösung aus dem Vorratstank entnommen und in einen zweiten Behälter gefüllt, die Menge der Bleed-Lösung in dem zweiten Behälter gemessen und dann entsorgt. Anschließend wird der zweite Behälter mit einer vorbestimmten Menge einer neuen Lösung (Feed-Lösung) aus dem Versorgungstank gefüllt und die vorbestimmte Menge der feed-Lösung in den Vorratstank gefüllt, um sicherzustellen, dass das zu- und abgeführte Volumen gleich ist und sich somit die Menge im Tank nicht ändert.

Nachteilig an diesem Verfahren ist, dass es letztendlich über einen längeren Zeitraum nicht kontinuierlich arbeitet. Zudem besteht durch die Zwischenspeicherung von Bleed-und-Feed-Lösung in dem zweiten Behälter die Gefahr der Kontamination der Feed-Lösung.

Die Aufgabe der vorliegenden Erfindung besteht darin, ein Bleed-und-Feed-Verfahren bereitzustellen, bei dem Kontaminationen vermieden werden, das quasikontinuierlich oder kontinuierlich arbeitet und auch bei anspruchsvollen Prozessen wie der Herstellung von Halbleiterbauelementen eingesetzt werden kann, sowie eine Vorrichtung anzugeben, auf der das Verfahren durchgeführt werden kann.

Die Aufgabe wird erfindungsgemäß durch die Merkmale der Ansprüche 1 und 13 gelöst.

Bei dem erfindungsgemäßen Verfahren ist zwischen dem Tank T1 für die Feed-Lösung und dem Prozesstank PT ein erster Aufnahmeraum G1 für die Feed-Lösung und entsprechend zwischen dem Prozesstank PT und dem Tank T2 für die Bleed-Lösung ein zweiter Aufnahmeraum G2 für die Bleed-Lösung vorgesehen. Aus dem Tank T1 wird der erste Aufnahmeraum G1 mit feed-Lösung gefüllt. Anschließend wird die feed-Lösung aus dem ersten Aufnahmeraum G1 mittels einer Pumpe in den Prozesstank PT gepumpt, wobei das Volumen der in den Prozesstank PT geförderten Menge der Feed-Lösung gemessen wird.

In analoger Weise wird unter Messung des Volumens der Bleed-Lösung die Bleed-Lösung aus dem Prozesstank PT in den zweiten Aufnahmeraum G2 für die Bleed-Lösung mittels der Pumpe P3 gepumpt und die Bleed-Lösung anschließend in den Tank T2 entleert.

Dadurch, dass die feed-Lösung erfindungsgemäß in einem anderen Aufnahmeraum als die Bleed-Lösung zwischengelagert wird, wird die Kontamination der Feed-Lösung vermieden.

Zur Erhöhung der Genauigkeit der jeweiligen Volumenflüsse werden weiterhin erfindungsgemäß die Volumen in bzw. aus dem Prozesstank PT nicht nur gemessen, sondern auch auf der Grundlage der Pumpleistung der Pumpen P2 und P3 berechnet und aus der Abweichung zwischen gemessenen und berechneten Volumen ein Korrekturfaktor berechnet, mit dem die Sollfördermenge der Pumpen P2 und P3 im nächsten Zyklus korrigiert wird.

Um die erforderliche Genauigkeit des Prozesses zu gewährleisten, sollten die Gefäße G1 und G2 derart konstruiert sein, dass der Fehler in der Bestimmung der Volumina in diesen Gefäßen kleiner als 0,1 %, vorzugsweise kleiner als 0,05 % und besonders bevorzugt kleiner als 0,02 % ist.

Das absolute Volumen von G1 und G2 wird von der maximal benötigten Bleed- und Feed-Rate, dem Volumen des Prozesstanks PT und dem erforderlichen Prozessfenster bestimmt, wobei die Genauigkeit der Dosierung einzig und allein von der Reproduzierbarkeit über einen sehr langen Zeitraum der Volumina der Gefäße G1 und G2 abhängt.

Vorzugsweise ist der Volumenfluss der Feed-Lösung beim Befüllen des ersten Aufnahmeraums G1 ein Vielfaches des Volumenflusses der Feed-Lösung aus dem ersten Aufnahmeraum G1 in den Prozesstank PT, insbesondere wenigstens das doppelte, vorzugsweise wenigstens das 5-fache und besonders bevorzugt wenigstens das 20-fache. Durch die hohen Volumenflüsse in den ersten Aufnahmeraum G1 und die daraus resultierende kurze Fülldauer kann über die erfindungsgemäße Regelung eine hohe Genauigkeit erreicht werden.

Ebenfalls sollte die Zeit, in der die Bleed-Lösung aus dem Prozesstank PT in den zweiten Aufnahmeraum G2 mittels der Pumpe P3 gepumpt wird, ein Vielfaches der Zeit betragen, in der die Bleed-Lösung aus dem zweiten Aufnahmeraum G2 in den Tank T2 entleert wird, vorzugsweise wenigstens das Doppelte.

Ein kontinuierlich arbeitendes Verfahren kann dadurch realisiert werden, dass das Füllen des ersten Aufnahmeraumes G1 (bzw. Entleeren des zweiten Aufnahmeraumes G2) durch den Tank T1 (bzw. in den Tank T2) und das Entleeren des ersten Aufnahmeraumes G1 (bzw. füllen des zweiten Aufnahmeraumes G2) in den bzw. aus dem Prozesstank PT durch verschiedene Leitungen erfolgt und die Pumpen P2 und P3 während eines Bleed-und-Feed-Zyklus nicht abgeschaltet werden. Dabei werden die Signale der Sensoren S1, S2, S3 und S4 in/an dem ersten und zweiten Aufnahmeraum G1 und G2 zur Berechnung der Korrekturfaktoren K1 und K2 für die Pumpe P2 und P3 genutzt.

Im Gegensatz zu diesem kontinuierlich arbeitenden System werden bei dem zuvor beschriebenen einfacheren System die Sensoren ausschließlich dazu genutzt, das Gefäß G1 wieder zu befüllen und das Gefäß G2 zu entleeren. Es wird dabei davon ausgegangen, dass diese Füllmenge immer konstant ist und damit zur Berechnung der Korrekturfaktoren benutzt werden kann.

Diese Korrektur kann weiterhin dadurch verbessert werden, dass die Volumenkorrektur $V_{k1}$ des ersten Zwischengefäßes G1 des nächsten Zyklus aus dem Sollvolumen, dem Korrekturvolumen des letzten Zyklus $V_{1k-1}$, dem kalibrierten Volumen $V_{G1}$ und dem über den kalibrierten Füllstand gefüllten Volumen berechnet wird. Das Fehlvolumen des letzen Zyklus wird daher im nächsten Zyklus mittels der Sollmenge des kompletten letzten Zyklus multipliziert mit dem Quotienten aus neuem und altem Korrekturfaktor korrigiert. Diese Menge muss dann in den Volumenstrom-Offset für eine gewisse Zeit, die möglichst kurz sein und maximal einen Zyklus betragen sollte, übersetzt.

Im Rahmen der vorliegenden Erfindung wird somit eine Kennlinienkorrektur der Pumpen P2 und P3 durchgeführt. Zudem erfolgt die Korrektur des Feed-Volumenstroms für externe Feedströme und die Korrektur des Bleed-Volumenstroms für externe Bleedströme (beispielsweis durch Verdunstung, Analyse etc.).

Aufgrund der erfindungsgemäßen Korrekturen ist eine Synchronität der Bleed- und Feed-Ströme nicht erforderlich.

Die vorliegende Erfindung betrifft weiterhin eine Vorrichtung zur Durchführung eines Bleed-und-Feed-Verfahrens, die jeweils einen Tank T1, T2 für die Feed- bzw. Bleed-Lösung umfasst sowie jeweils einen ersten Aufnahmeraum G1 zur Zwischenlagerung der Feed-Lösung und einen zweiten Aufnahmeraum G2 zur Zwischenlagerung der Bleed-Lösung und einen Prozesstank PT sowie Pumpen P1, P4 für den flüssigkeitstransport zwischen Tank T1, T2 und Aufnahmeraum G1 und G2 und Pumpen P2, P3 für den Flüssigkeitstransport zwischen dem Aufnahmeraum G1, G2 und dem Prozesstank PT, Sensoren S1, S2, S3 und S4 zur Triggerung vorgegebener Füllstände in den Aufnahmeräumen G1, G2, Ventile (V1, V4) sowie ein Prozessrechner PR, der den Fluss der Bleed- bzw. feed-Lösung aus den bzw. in den Prozesstank PT steuert.

Selbstverständlich kann das erfindungsgemäße Verfahren auch mit mehreren Feed-Systemen und auch mit mehreren Bleed-Systemen und mehreren Feed-Systemen durchgeführt werden, wobei für jedes System die entsprechenden Aufnahmeräumen, Tanks und Pumpen vorzusehen sind.

Die Erfindung betrifft weiterhin die Erweiterung des Bleed-und-Feed-Systems durch ein Analysesystem und durch ein zusätzliches System zur Aufbereitung der Bleed-Lösung. Die Korrektur der Volumenströme kann durch die Analyse der Bleed-Substanzen, die Analyse der Feed-Substanzen und/oder die Analyse der wiederaufbereiteten Bleed-Flüssigkeit erfolgen.

Die Erfindung wird nachfolgend anhand von Ausführungsbeispielen näher beschrieben.

Es zeigen:

Fig. 1 :     den prinzipiellen Aufbau der erfindungsgemäßen Bleed- und-Feed-Vorrichtung

Fig. 2:     die Signale der Sensoren und Regelung der Pumpen wäh- rend eines Bleed-und-feed-Zyklus mit Konzentrations- und Volumenverläufen in Abhängigkeit von der Zeit für das Sys- tem gemäß Fig. 1

Fig. 3:     die Bleed-und-Feed-Vorrichtung aus fig. 1 mit einer ge- trennten Zu- und Abführung aus den Aufnahmeräumen G1 und G2

Fig. 4:     die Signale der Sensoren und Regelung der Pumpen wäh- rend eines Bleed-und-Feed-Zyklus mit Konzentrations- und Volumenverläufen in Abhängigkeit von der Zeit für das Sys- tem gemäß Fig. 3

Fig. 5:     die Signale der Sensoren und Regelung der Pumpen wäh- rend eines Bleed-und-Feed-Zyklus unter Ausgleichung tole- ranzbedingter Ungenauigkeit für die Vorrichtung aus Fig. 3

Fig.        6: Blockschema der Regelung und Steuerung der Pumpen für die Vorrichtung aus fig. 3

Fig. 7:     ein Bleed-und-Feed-System mit Nachdosierung

Fig. 8:     ein Bleed-und-Feed-System mit einem zusätzlichen Analy- sesystem

Fig. 9:     ein Bleed-und Feed-System mit zusätzlicher Analytik und Aufbereitung

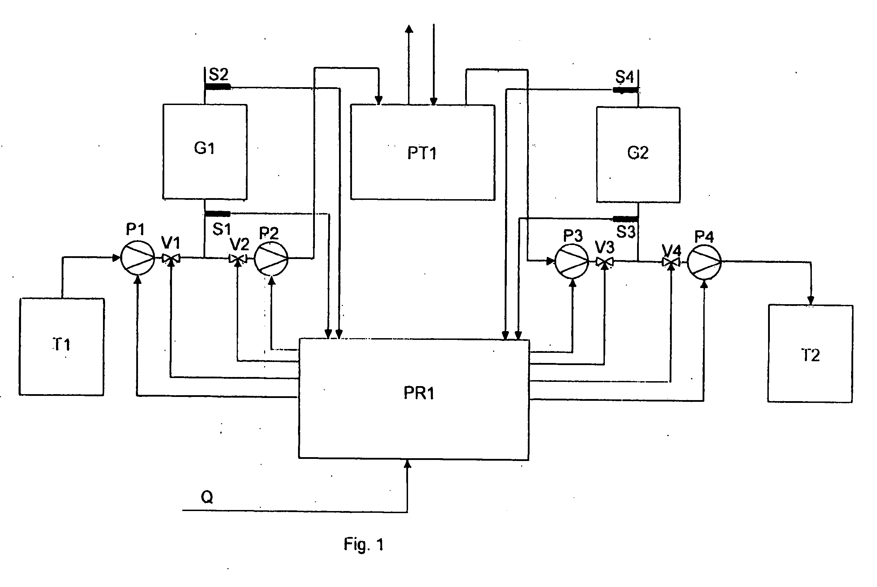

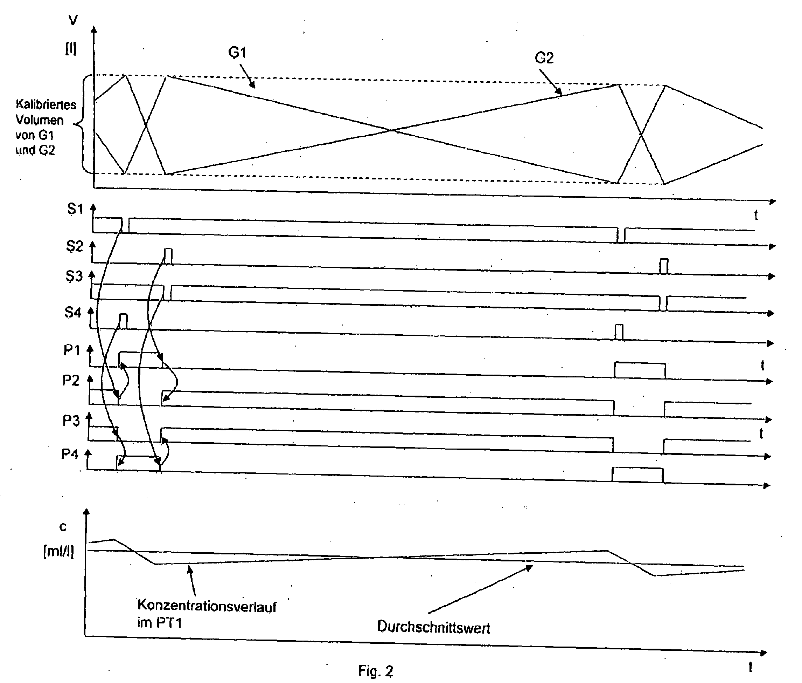

Der prinzipielle Aufbau des erfindungsgemäßen Bleed-und-Feed-Systems ist in der **Fig. 1** dargestellt. Die Feed-Lösung wird mit hoher Flussrate aus Tank T1 mit der Pumpe P1, geöffnetem Ventil V1 und geschlossenem Ventil V2 in den ersten Aufnahmeraum G1 für die Feed-Lösung, der als Zwischengefäß ausgebildet ist, gepumpt. Spricht der Sensor S2 an, so wird Ventil V1 geschlossen und Pumpe P1 abgestellt (vgl. auch **Fig. 2**). Dieser Füllvorgang des Zwischengefäßes mit der feed-Lösung dauert typischerweise wenige Sekunden bis maximal einige Minuten.
Danach wird die Pumpe P2 gestartet und das Ventil V2 geöffnet. Der Prozessrechner PR steuert die Förderrate der Pumpe P2, um den gewünschten Volumenfluss der Feed-Lösung in den Prozesstank PT zu erhalten, wobei das Zwischengefäß entleert wird. Spricht der Sensor S1 an, so wird Ventil V2 geschlossen und Pumpe P2 ausgeschaltet (vgl. Fig. 2) und der Füllvorgang des Zwischengefäß G1 beginnt wieder wie oben beschrieben.
Ein Feed-Zyklus kann typischerweise von 30 Min. bis mehrere Stunden dauern.
Bei der Bleed-Lösung wird nach dem gleichen Prinzip wie bei der Feed-Lösung verfahren. Die Bleed-Lösung wird mit der Pumpe P3 aus dem Prozesstank PT bei geöffnetem Ventil V3 und geschlossenem Ventil V4 in den zweiten Aufnahmeraum G2 für die Bleed-Lösung, der in dieser Ausführungsform ebenfalls als Zwischengefäß G2 ausgebildet ist, gepumpt. Spricht der Sensor S4 an, so wird Ventil V3 geschlossen und Pumpe P3 abgeschaltet. Danach wird das Zwischengefäß G2 mit hoher Flussrate in Tank T2 entleert, indem die Pumpe P4 eingeschaltet und Ventil V4 geöffnet wird. Spricht der Sensor S3 an, so wird Ventil V4 geschlossen und Pumpe P4 ausgeschaltet.
Danach wird Pumpe P3 eingeschaltet und Ventil V3 geöffnet und ein neuer Bleed-Zyklus beginnt. Ein Zyklus kann typischerweise von 30 Minuten bis mehrere Stunden dauern.
Das Volumen zwischen dem Ansprechen des Sensors S2 und dem Abfallen des Sensors S1 in dem Zwischengefäß G1, das das entsprechende Chemikaliengemisch umfasst, muss genauestens abgemessen werden. Entsprechend wird mit dem zweiten Zwischengefäß G2 verfahren.
Somit ist das gemessene Volumen $V_{FE}$ und $V_{BL}$, das die Pumpe P2 und P3 in einem Zyklus in einer bestimmten Zeitdauer gefördert hat, bekannt.
Die Konstruktion der Zwischengefäße G1 und G2 mit den dazugehörigen Sensoren S1, S2, S3 und S4 muss so ausgestaltet sein, dass eine sehr hohe Wiederholgenauigkeit (Langzeitstabilität) des kalibrierten Volumens in G1 und G2 gewährleistet ist.
Werden kurzzeitstabile Pumpentypen für P2 und P3 eingesetzt, kann der Prozessrechner PR die fördermenge zu jedem Zeitpunkt exakt berechnen. Bei jedem Zyklus wird für die Pumpen P2 und P3 jeweils ein Korrekturfaktor errechnet. Mit diesen Korrekturfaktoren werden die Sollwertfördermengen der Pumpen korrigiert, so dass die Steuerung die Pumpen sehr genau auf eine exakte Fördermenge einstellen kann. Diese Korrekturfaktoren werden bei jedem Zyklus neu berechnet und nötigenfalls für den nächsten Zyklus angepasst. Wird nach Beendigung eines Zyklus eine Abweichung von Soll-zu-Ist-Volumen festgestellt, wird dies bei der Berechnung der Fördermenge im nächsten Zyklus berücksichtigt und allfällige Fehler korrigiert.
Tritt Verschleiß an den Pumpen P2 oder P3 auf, verändert dies den Korrekturfaktor sehr schnell oder der Korrekturfaktor weicht stark von seinem Nominalwert ab. Dies kann durch den Prozessrechner PR festgestellt werden und dem Anwender einen Hinweis auf eine notwendige Reparatur geben, bevor es zu einem Ausfall kommt.
Genauso ist auch die Pumpzeit der Pumpen P1 und P4 zu überwachen. Bei starker Veränderung der Werte kann ein Hinweis an den Anwender erfolgen, obwohl die Genauigkeitsanforderungen an P1 und P4 nicht so groB sind. Es ist nur wichtig, dass die maximale Füll- bzw. Entleerungszeit nicht überschritten wird. Die erreichte Genauigkeit hängt ausschließlich von der Genauigkeit des absoluten Volumens der Gefäße G1 und G2 ab (bzw. der Genauigkeit des jeweiligen Füllvolumens) ab.
Bei der Volumengenauigkeit der verwendeten Gefäße wird mit dem erfindungsgemäßen System und Verfahren beim absoluten ausgetauschten Volumen eine Genauigkeit von 0,05% und damit Volumendifferenzen zwischen der Bleed- und Feed-Lösung von weniger als 0,1 % erreicht.

Bei der in Fig. 1 dargestellten Ausführungsform sind die füllleitung FuL und Ansaugleitung AnL für das erste Zwischengefäß G1 die gleiche Leitung, und die Förderpumpen P2 und P3 werden zur Erhöhung der Genauigkeit beim Befüllen des ersten Zwischengefäßes G1 für die Feed-Lösung mit der Pumpe P1 und Entleeren des zweiten Zwischengefäßes G2 für die Bleed-Lösung mit der Pumpe P4 ausgeschaltet. Wären die Pumpen P2 und P1 gleichzeitig eingeschaltet, so würde sich die Förderrate (wegen des erhöhten Drucks vor der Pumpe) von P2 stark ändern. Dies würde zu einer größeren Ungenauigkeit führen. Entsprechendes gilt auch für das zweite Zwischengefäß G2.

Die Vorrichtung und das Verfahren aus **Fig. 1** arbeitet quasikontinuierlich. Der Konzentrationsverlauf in **Fig. 2** ist noch schwach sägezahnartig. Durch den Vergleich der gemessenen und berechneten Volumenflüsse und Berechnung von Korrekturfaktoren der Pumpe P2 und P3 bei einem jeden Zyklus wird eine außerordentlich hohe Genauigkeit und damit Zuverlässigkeit des Verfahrens erreicht.

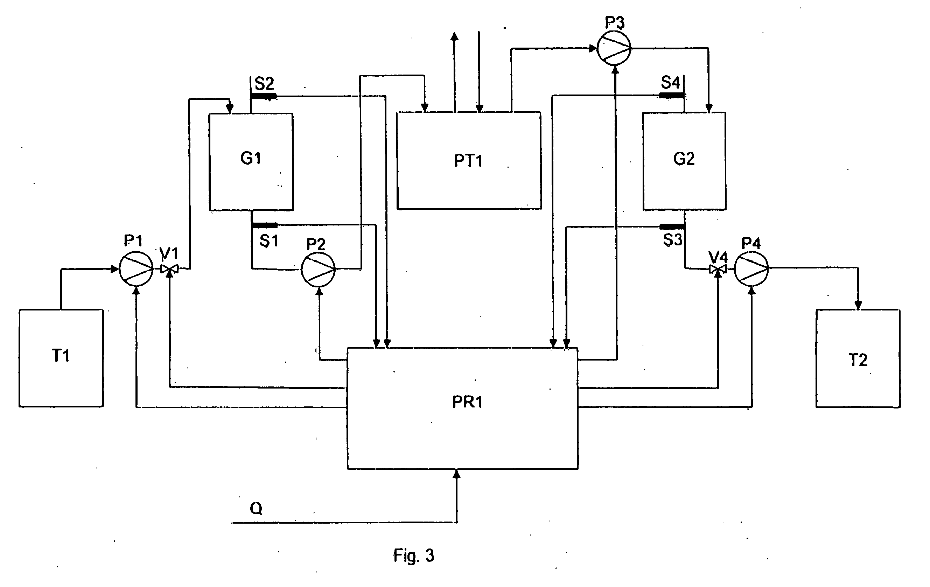

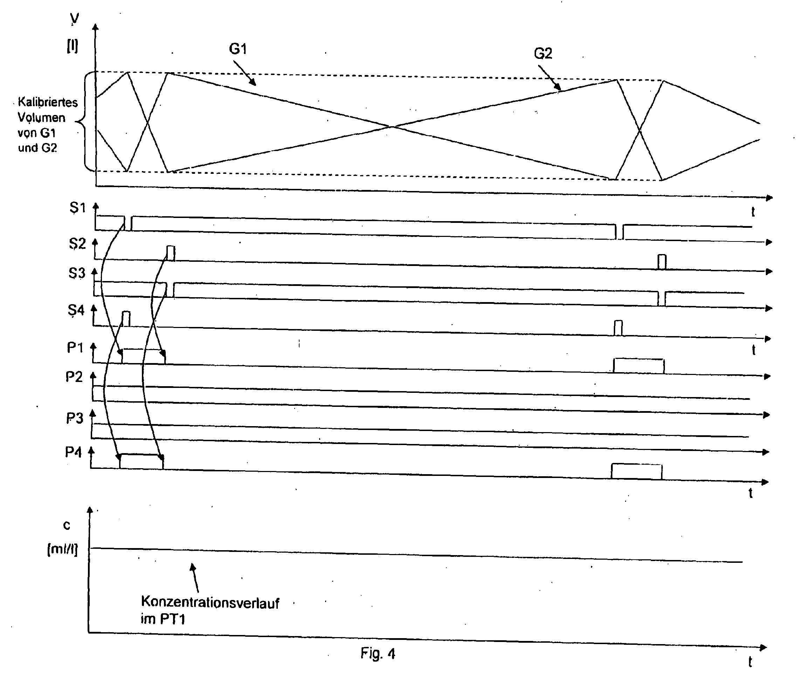

Ein vollständig kontinuierlich arbeitendes Bleed-und-Feed-System ist in **Fig. 3** dargestellt. Hierbei werden die Leitungen FuL und AnL getrennt ausgeführt. Dies ermöglicht, die Bleed-und-Feed-Pumpen P2 und P3 auch während des Füllens des ersten Zwischengefäßes G1 und dem Entleeren des zweiten Zwischengefäßes G2 weiterlaufen zu lassen. Dadurch, dass selbst nach Abfallen des Sensors S1 immer noch ein hinreichendes Volumen an in den Prozesstank PT zu pumpende Feed-Lösung vorhanden ist, fördert die Pumpe P2 fortwährend Feed-Lösung in den Prozesstank PT, somit im Gegensatz zu Fig. 1 auch dann, wenn das Zwischengefäß G1 kurzfristig aus T1 mit Feed-Lösung befüllt wird (vgl. **Fig. 4**). **E**ntsprechend wird auch kontinuierlich durch die Pumpe P3 Bleed-Lösung aus dem Prozesstank PT abgepumpt, auch in der Zeitspanne, in der aus dem Zwischengefäß G2 mit hoher Förderrate Bleed-Lösung mit der Pumpe P4 in den Tank T2 abgepumpt wird. Nachdem der Fluss der Feed-Lösung in den Prozesstank PT und der Fluss der Bleed-Lösung aus dem Prozesstank PT konstant sind, da die Pumpen P2 und P3 nicht mehr abgeschaltet werden und somit keine Totzeit mehr existiert, ist die Konzentration im Prozesstank zeitlich konstant und das Bleed-und-Feed-Verfahren arbeitet kontinuierlich.

Auch bei dieser Ausführungsform erfasst der Prozessrechner PR die geförderten Volumina exakt und errechnet die Korrekturfaktoren. Hierdurch kann die Konstanz der Konzentration im Prozesstank PT weiter erhöht werden, ohne die Genauigkeiten der Volumendifferenz und des ausgetauschten Volumens zu beeinträchtigen.

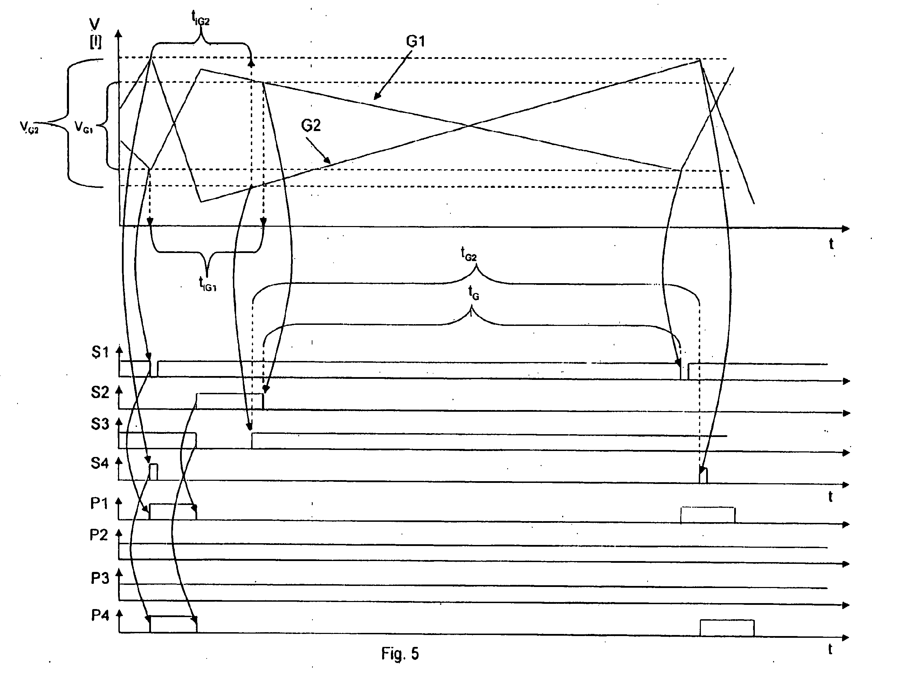

Im Rahmen der vorliegenden Erfindung können weiterhin toleranzbedingte Ungenauigkeiten verminderte werden, wie in **Fig. 5** an einem Beispiel dargestellt ist.

Je nach den verwendeten Pumpen (P1, P4) und Ventilen (V1, V4) kann die Füllmenge beim Füllen des ersten Zwischengefäßes G1 und beim Entleeren des zweiten Zwischengefäßes G2 variieren. So kann das erste Zwischengefäß G1 beispielsweise überfüllt werden, wenn bei Erreichen der Maximalposition des Sensors S2 die Pumpe P1 nicht unmittelbar abgeschaltet wird, da die Füllrate der Pumpe P1 in das Zwischengefäß G1 hoch ist. In diesem Fall "überschießt" das in das erste Zwischengefäß G1 gepumpte Volumen der Feed-Lösung das kalibrierte Volumen $V_{G1}$

Ebenso kann es zu einer Reduzierung des Volumens $V_{G2}$ der Bleed-Lösung kommen, weil bei Erreichen der Minimalposition des Sensors S3 die schnelle Pumpe P4 nicht unmittelbar abgeschaltet wird. Da das Entleeren des ersten Zwischengefäßes G1 mit der Pumpe P2 langsam erfolgt, ebenso auch das Füllen des zweiten Zwischengefäßes G2 mit P3, verwendet der Prozessrechner PR in dieser Variante die Sensorsignale (S1, S2, S3 und S4) für die Berechnung der Korrekturfaktoren, wodurch eine sehr hohe Genauigkeit erzielt werden kann.

Diese beispielhaft beschriebenen und alle anderen Ungenauigkeiten, woher sie auch immer kommen, werden im nächsten Zyklus korrigiert. Bedingung ist lediglich, dass das G1 und G2 nicht völlig leer ist (die folgende Pumpen Luft zieht) und G1/G2 nicht überlaufen.

Während eines Feed-Zyklus wird das kalibrierte Volumen $V_{G1}$ des Zwischengefäßes G1 während der Zeitdauer $t_{G1}$ dosiert. Darüber hinaus wird in der Zeitspanne $t_{iG1}$ ein zusätzliches Volumen dosiert, das sich errechnet aus der Integration des Fördervolumens der Pumpe P2 über die Integrationszeit $t_{iG1}$. $t_{iG1}$ ist die Zeit zwischen der fallenden Flanke des Sensors (S1) und der fallenden Flanke des Sensors S2.

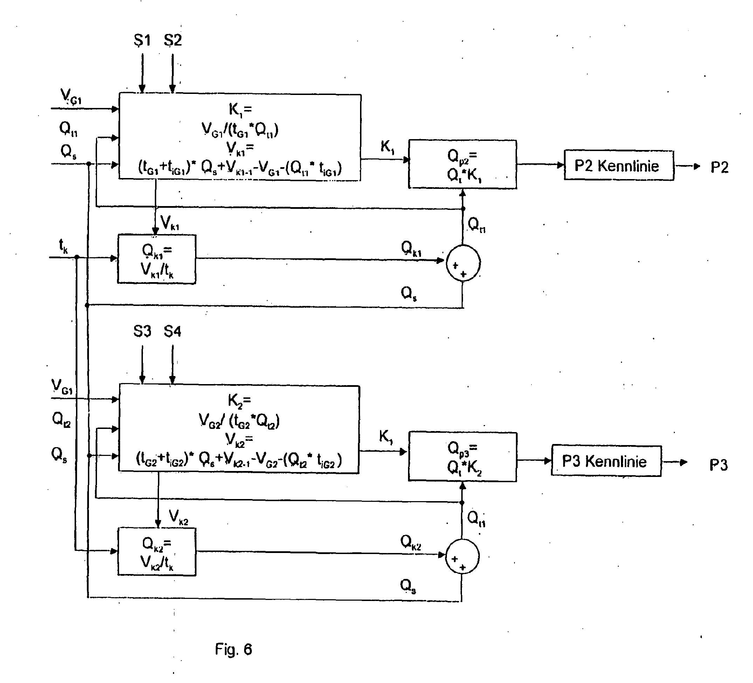

Analog wird das Volumen des Bleed-Zyklus errechnet aus dem kalibrierten Volumen $V_{G2}$ des zweiten Zwischengefäßes G2 und dem zusätzlichen Fördervolumen integriert über $t_{iG2}$. Durch diese Verbesserungen wird das System wesentlich weniger anfällig für Toleranzen, die bei der Fertigung und während des Betriebs der Anlage entstehen. In **Fig.6** ist das Blockschema der Regelung und Steuerung der Pumpen P2 und P3 für die Variante gemäß Fig. 5 dargestellt. Dies stellt eine von mehreren Möglichkeiten der Implementierungen dar.

Die Bedeutung der einzelnen Formeln und Parameter in Fig. 6 sind wie folgt :

$$K_1 = \frac{V_{G1}}{\int_{t_{G1}} Q_1(t)\,dt}$$

| | |
|---|---|
| $K_1$ | Korrekturfaktoren für Pumpe P2 |
| $V_{G1}$ | Kalibriertes Volumen des G1 (Ist-Volumen) |
| $\int_{tG1} Q_1(t)dt$ | Das Soll-Volumen im ersten Zwischengefäß G1 |
| $t_{G1}$ | Zeitintervall zwischen der fallenden Flanke von S2 und der fallenden Flanke von S1 (siehe Fig. 5 und 6) |
| $Q_1(t)$ | Volumenstrom der Pumpe 2 zum Zeitpunkt t $V_{k1}= \int_{tG1}+t_{iG1} Q_S(t)dt + V_{1K-1}-V_{G1} - \int_{tiG1}Q_1(t)dt$ |
| $V_{k1}$ | Volumen, um das der nächste Zyklus korrigiert werden muss |
| $\int t_{G1}+t_{iG1} Q_S(t)dt$ | Soll-Volumen |
| $V_{1K-1}$ | Korrektur-Volumen vom letzten Zyklus |
| $V_{G1}$ | Kalibriertes Volumen des G1 (Ist-Volumen) |
| $\int_{tiG1}Q_1(t)dt$ Volumen, | das über den kalibrierten Füllstand gefüllt wurde |
| $t_{iG1}$ | Zeitintervall zwischen fallender Flanke von S1 und fallender Flanke von S2 (siehe Fig.5) |

$$Q_{k1}=V_{k1}/t_k$$

| | |
|---|---|
| $Q_{k1}$ | Volumenstrom (konstant während $t_k$), der notwendig ist, um das Volumen $V_{k1}$ zu korrigieren |
| $t_k$ | Zeit, in der das Volumen $V_{k1}$ korrigiert werden soll (diese Zeit wird sehr kurz gewählt, da mit $V_{k1}$ möglichst schnell ausgeglichen wird) |

Für Pumpe 3 Bleed wird analog verfahren wie für Pumpe 2 Feed und in Fig.6 dargestellt.

**Erweiterung mit Nachdosierung**

Es gibt Anwendungen, bei denen Abbauprodukte oder Aufkumulierungen von Stoffen entstehen, die nur über ein Bleed-und-Feed-System verdünnt, aber trotzdem nicht mit einer Feed-Lösung aller Stoffkonzentrationen konstant gehalten werden können. In diesen Fällen werden Einzelsubstanzen in den Prozesstank PT je nach individuellem Verbrauch zugegeben.

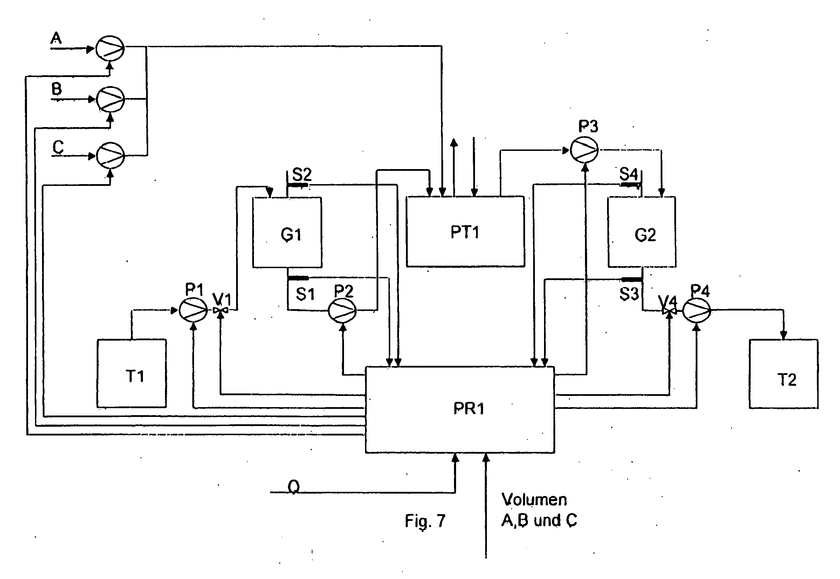

In **Fig.7** ist schematisch ein Beispiel dargestellt, in dem die Substanzen A, B und C über eigene Pumpen P4, P5, P6 von PR gesteuert zugegeben werden. Dies hat als Konsequenz, dass bei der Zugabe von A, B oder C oder bei jeder beliebigen Kombination der Substanzen der Volumenstrom der Feed-Lösung reduziert werden muss, um das Gleichgewicht von Zu- und Abfluss in den Prozesstank PT nicht zu stören. Es ist auch denkbar, dass der Volumenstrom der Bleed-Lösung entsprechend erhöht wird. Welches System das bessere Ergebnis bringt, hängt jeweils von der Zusammensetzung und dem Verhalten der Chemikalien ab.

**Erweiterung mit Analysesystem**

Die bis jetzt beschriebenen Bleed-und-Feed-Lösungen werden von extern gesteuert, meistens nach Produktionsdurchsatz. Dies führt in vielen Fällen zu guten Ergebnissen und zu relativ langen Lebensdauer der Bäder. Durch die Ergänzung des erfindungsgemäßen Bleed-und-Feed-Systems mit einem Analytiksystem kann ein geschlossener Regelkreis erhalten werden. Das Analysesystem muss in der Lage sein, die einzelnen Stoffkonzentrationen, die entscheidend für das Produktionsergebnis sind, zu bestimmen.

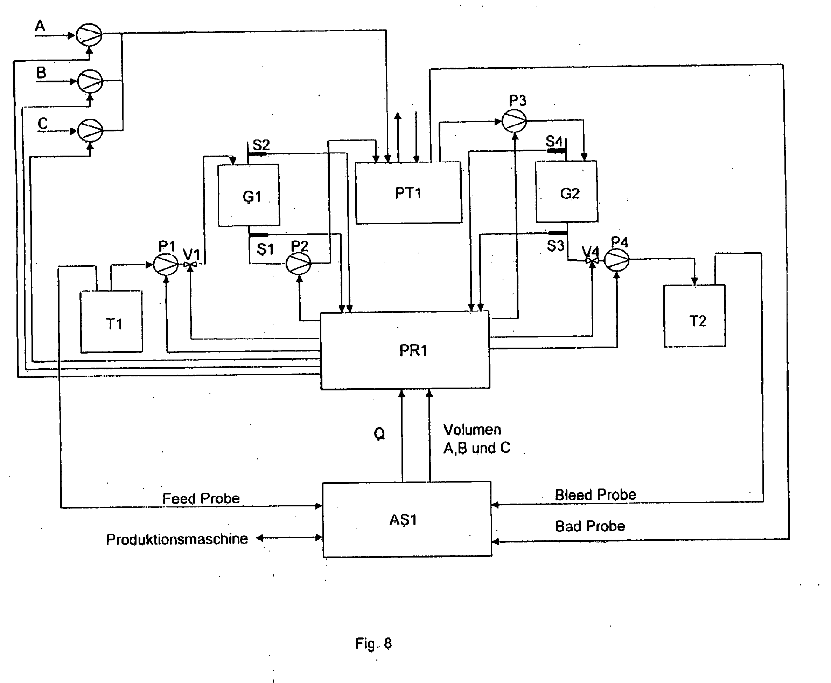

Eine mögliche Variante einer mit einem Analysesystem AS gekoppelten Bleed-und-Feed-Vorrichtung ist in **Fig. 8** dargestellt. Das Analysesystem AS in Fig.8 analysiert jeweils, wenn die Feed-Lösung in T1 dosiert wird, wenn diese gewechselt wird oder T1 als Ganzes ausgetauscht wird. In Abhängigkeit der Stoffkonzentrationen wird der notwendige Volumenstrom Q für das Bleed-und-Feed-System errechnet. Damit kann eine Feed-Lösung, die nicht exakt der theoretischen Konzentration entspricht, verwendet werden. Es werden dann entsprechend im Prozessrechner die Volumenströme für einen vorgegebenen Produktionsdurchsatz korrigiert.

Während der Produktion werden regelmäßig Stoffkonzentrationen im Prozesstank PT mithilfe des Analysesystem AS bestimmt. Je nach Ergebnis wird Q für das Bleed-und-Feed-System angepasst und, falls erforderlich, die Zusatzkomponenten wie zum Beispiel A, B oder C nachdosiert, um die Stoffkonzentrationen im Prozesstank PT möglichst genau auf dem Sollwert zu halten. In regelmäßigen Abständen wird auch der Bleed-Tank T2 in Fig.8 analysiert, um die Effizienz der Systems zu überprüfen.

### Erweiterung mit Aufbereitungsanlage

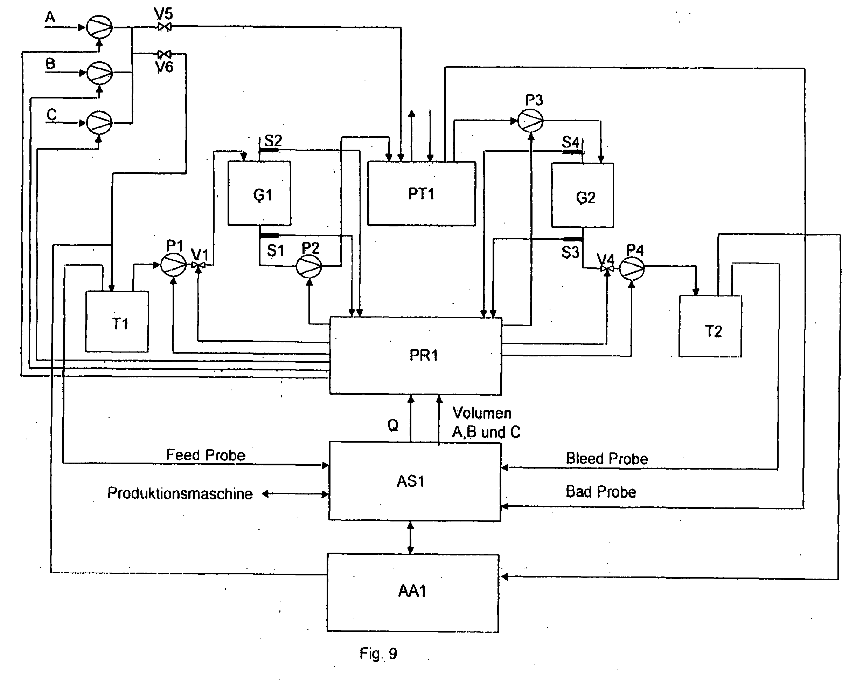

Wird ein Bleed-und-Feed-System mit Analytik zusätzlich mit einer Aufbereitungsanlage gekoppelt, wie in fig. 9 dargestellt, so entsteht ein geschlossener Kreislauf. Dies reduziert den Abfall, der durch die Produktion verursacht wird, wesentlich und senkt auch noch die Produktionskosten. Bislang sind nur Systeme bekannt, bei denen die Bleed-Lösung in einem Batchverfahren aufbereiten wird, wobei die Bleed-und-feed-Lösungen transportiert werden müssen. Mit diesem integrierten System kann der Transport vermieden werden. Die Umweltbelastung wird durch den vermiedenen Transport reduziert, ebenso das Risiko, bei einem Unfall auf dem Transportweg eine Umweltverschmutzung zu verursachen. Auch die Gesamtkosten werden durch die Erweiterung in der Aufbereitungsanlage weiter vermindert.

Die Erfindung wird nachfolgend anhand eines Beispiels näher beschrieben.

### Beispiel einer integrierten Aufbereitungsanlage:

In der Halbleiterfertigung wird Kupfer auf Wafern abgeschieden. Das Kupferbad beinhaltet typischerweise Kupfersulfat, Schwefelsäure, Chlorid und mehrere organische Verbindungen. In der Bleed-Lösung eines solchen Bades sind die Abbauprodukte der organischen Verbindungen der limitierende Faktor für die Lebensdauer eines solchen Bades. In einer Aufbereitungsanlage können die organischen Verbindungen durch Oxidation mit UV und / oder chemischen Mitteln komplett abgebaut werden.

Nach dem Reinigen können die organischen Stoffe wieder in den Feed-Tank T1 zugegeben werden (wie in Fig. 9 dargestellt als A, B und C und Ventil V6). Typischerweise werden die Additive auch benutzt, um die Sollkonzentrationen im Prozesstank PT konstant zu halten. Dies erfolgt auch über die Pumpen von A, B und C und Ventil V5.

Diese Art von Aufbereitung ist auch für andere chemischen Produktionsprozessen anwendbar. Es werden dabei verschieden Techniken zum Einsatz kommen wie Filtration, Elektrolyse, präparative HPLC und weitere.

### Patentansprüche

**1.** Verfahren zur Durchführung eines Bleed-und-Feed von Prozesslösungen in einem Prozesstank, bei dem die Feed-Lösung aus einem ersten Tank T1 in einen ersten Aufnahmeraum G1 für die Feed-Lösung gepumpt wird und der erste Aufnahmeraum G1 anschließend mittels einer Pumpe P2 in den Prozesstank PT entleert wird, wobei das Volumen der in den Prozesstank PT geförderten Menge der Feed-Lösung gemessen wird, bei dem die Bleed-Lösung aus dem Prozesstank PT in einen zweiten Aufnahmeraum G2 für die Bleed-Lösung mittels einer Pumpe P3 gepumpt wird, wobei das Volumen der aus dem Prozesstank PT in den zweiten Aufnahmeraum G2 geförderten Menge der Bleed-Lösung gemessen wird, und die Bleed-Lösung in dem zweiten Aufnahmeraum G2 anschließend in den zweiten Tank entleert wird, und wobei der erste Aufnahmeraum G1 von dem zweiten Aufnahmeraum G2 verschieden ist und wobei aus dem Vergleich der gemessenen und berechneten mit den Pumpen P2 und P3 geförderten Volumina der Bleed- bzw. Feed-Lösung jeweils ein Korrekturfaktor berechnet wird, mit dem die Sollfördermenge der Pumpen P2 und P3 im nächsten Zyklus korrigiert wird.

**2.** Verfahren nach Anspruch 1, **dadurch gekennzeichnet, dass** die Aufnahmeräume G1, G2 derart konstruiert sind, dass der Fehler in der Bestimmung der Volumina kleiner 0,1%, vorzugsweise kleiner 0,05% und besonders bevorzugt kleiner als 0,02% ist.

3. Verfahren nach einem der vorangegangenen Ansprüche, **dadurch gekennzeichnet, dass** der Volumenfluss der Feed-Lösung beim Befüllen des ersten Aufnahmeraums G1 aus dem Tank T1 wenigstens das doppelte, vorzugsweise wenigsten das 5-fache und besonders bevorzugt wenigstens das 20-fache des Volumenflusses der Feed-Lösung bei Befüllen des Prozesstanks PT ist.

4. Verfahren nach einem der vorangegangenen Ansprüche, **dadurch gekennzeichnet, dass** die Zeit, in der die Feed-Lösung aus dem ersten Aufnahmeraum G1 mittels der Pumpe P2 in den Prozesstank PT entleert wird, ein Vielfaches der Zeit beträgt, in der die Feed-Lösung aus dem ersten Tank T1 in den ersten Aufnahmeraum G1 gepumpt wird, vorzugsweise wenigstens das doppelte, vorzugsweise das 5- und besonders bevorzugt wenigstens das 20-fache.

5. Verfahren nach einem der vorangegangenen Ansprüche, **dadurch gekennzeichnet, dass** das Füllen des ersten Aufnahmeraums G1 (bzw. Entleeren des zweiten Aufnahmeraums G2) durch den Tank T1 (bzw. in den Tank T2) und das Entleeren des ersten Aufnahmeraums G1(bzw. Füllen des zweiten Aufnahmeraums G2) in den (aus dem) Prozesstank PT durch dieselbe Leitung erfolgt-und die Pumpen P1 (bzw. P4) beim Betrieb der Pumpe P2 (bzw. P3) und die Pumpen P2 (bzw. P3) beim Betrieb der Pumpe P1 (bzw. P4) ausgeschaltet werden.

6. Verfahren nach einem der Ansprüche 1 bis 4, **dadurch gekennzeichnet, dass** das Füllen des ersten Aufnahmeraums G1 (bzw. Entleeren des zweiten Aufnahmeraums G2) durch den Tank T1 (bzw. in den Tank T2) und das Entleeren des ersten Aufnahmeraums G1(bzw. Füllen des zweiten Aufnahmeraumes G2) in den (aus dem) Prozesstank PT durch verschiedene Leitungen erfolgt und die Pumpen P2 und P3 während eines Bleed-und-Feed-Zyklus nicht abgeschaltet werden.

7. Verfahren nach Anspruch 6, **dadurch gekennzeichnet, dass** an bzw. in dem ersten und/oder zweiten Aufnahmeraum G1, G2 Sensoren (S1, S2, S3, S4) zur Bestimmung der füllhöhe vorgesehen sind und die Sensorsignale (S1, S2, S3, S4) in die Berechnung der Korrekturfaktoren (K1, K2) für die Pumpen (P2, P3) eingehen.

8. Verfahren nach Anspruch 6, **dadurch gekennzeichnet, dass** die Volumenkorrektur $V_{K1}$ des ersten Aufnahmeraums G1 nach dem nächsten Zyklus aus dem Sollvolumen, dem Korrekturvolumen des letzten Zyklus $V_{1k-1}$, dem kalibriertem Volumen $V_{G1}$ und das über den kalibrierten Füllstand gefüllten Volumen berechnet.

9. Verfahren nach einem der vorangegangenen Ansprüche, **dadurch gekennzeichnet, dass** eine Kennlinienkorrektur der Pumpen P2 und P3 erfolgt.

10. Verfahren nach einem der vorangegangenen Ansprüche, **dadurch gekennzeichnet, dass** die Korrektur des Feed-Votumenstroms für externe Feedströme und/oder die Korrektur des Bleed-Volumenstroms durch externe Bleedströme erfolgt.

11. Verfahren nach einem der vorangegangenen Ansprüche, **dadurch gekennzeichnet, dass** die Korrektur der Volumenströme durch Analyse der Feed- und /oder der Bleed-Substanzen und /oder durch Analyse der wiederaufbereiteten Bleed-Lösung erfolgt.

12. Verfahren nach einem der vorangegangenen Ansprüche, **dadurch gekennzeichnet, dass** die Bleed- und Feed-Ströme nicht synchron sind.

13. Vorrichtung eines Bleed-und-Feed-Verfahrens, **dadurch gekennzeichnet, dass** die Vorrichtung jeweils einen Tank T1, T2 für die Feed- bzw. Bleed-Lösung umfasst sowie jeweils einen Aufnahmeraum G1, G2 zur Zwischenlagerung der Feed- bzw. Bleed-Lösung und einen Prozesstank PT sowie Pumpen P1, P4 für den Flüssigkeitstransport zwischen Tank T1, T2 und Aufnahmeraum G1, G2 und Pumpen P2, P3 für den Flüssigkeitstransport zwischen dem Aufnahmeraum G1, G2 und dem Prozesstank PT, Sensoren S1, S2, S3 und S4 zur Bestimmung der Füllhöhe in den Aufnahmeräumen G1, G2, Ventile (V1, V2, V3, V4) sowie einem Prozessrechner PR, der den fluss der Bleed-bzw. Feed-Lösung aus dem bzw. in den Prozesstankt PT steuert.

14. Vorrichtung nach Anspruch 13, **dadurch gekennzeichnet, dass** mehrere Feed-Systeme mit mehreren Aufnahmeräumen zur Zwischenlagerung der Feed-Lösungen, Tanks und Pumpen und ein oder mehr Bleed-Systeme mit den Aufnahmeräumen zur Zwischenlagerung, Tanks und Pumpen vorgesehen sind.

**15.** Vorrichtung nach Anspruch 13 oder 14, **dadurch gekennzeichnet, dass** die Vorrichtung zusätzlich ein System zur Analyse der Bleed-Lösung umfasst.

**16.** Vorrichtung nach einem der Ansprüche 13 bis 15, **dadurch gekennzeichnet, dass** die Vorrichtung zusätzlich ein System zur Aufbereitung der Bleed-Lösung umfasst.


**Claims**

**1.** Method for carrying out a bleed and feed of process solutions in a process tank, in which the feed solution is pumped out of a first tank T1 into a first receiving space G1 for the feed solution, and the first receiving space G1 is subsequently emptied into the process tank PT by means of a pump P2, whereby the volume of the delivered amount of feed solution in the process tank PT is measured, in which the bleed solution is pumped out of the process tank PT by means of a pump P3 into a second receiving space G2 for the bleed solution, whereby the volume of the delivered amount of bleed solution from the process tank PT in the second receiving space G2 is measured, and the bleed solution in the second receiving space G2 is subsequently emptied into the second tank, and whereby the first receiving space G1 is different from the second receiving space G2, and whereby a correction factor is always calculated from a comparison of the measured and calculated volumes of the bleed and feed solution delivered by pumps P2 and P3, with which correction factor the nominal delivery volume of pumps P2 and P3 are corrected in the next cycle.

**2.** Method according to claim 1, **characterised in that** the receiving spaces G1 and G2 are constructed in such a way that error in determining the volumes is less than 0.1%, preferably less than 0.05% and particularly preferably, less than 0.02%.

**3.** Method according to any one of the previous claims, **characterised in that** the volume flow of the feed solution for filling the first receiving space G1 from tank T1 is at least double, preferably at least 5 times the value, and particularly preferably, at least 20 times the value of the volume flow of the feed solution for filling the process tank PT.

**4.** Method according to any one of the previous claims, **characterised in that** the time, in which the feed solution is emptied out of the first receiving area G1 into the process tank PT by means of the pump P2, is a multiple of the time in which the feed solution is pumped out of the first tank T1 into the first receiving space G1, preferably at least double, preferably 5 times the value, and particularly preferably, at least 20 times the value.

**5.** Method according to any one of the previous claims, **characterised in that** the filling of the first receiving space G1 (respectively emptying of the second receiving space G2) by the tank T1 (respectively into tank T2) and the emptying of the first receiving space G1 (respectively filling of the second receiving space G2) into (from the) process tank PT is done by the same pipe, and the pump P1 (respectively P4) is switched off on use of pump P2 (respectively P3), and pump P2 (respectively P3) is switched off on use of pump P1 (respectively P4).

**6.** Method according to any one of claims 1 to 4, **characterised in that** the filling of the first receiving space G1 (respectively emptying of the second receiving space G2) by tank T1 (respectively into tank T2), and the emptying of the first receiving space G1 (respectively filling of the second receiving space G2) into the (from the) process tank PT is done by different pipes, and the pumps P2 and P3 are not switched off during a bleed and feed cycle.

**7.** Method according to claim 6, **characterised in that** sensors (S1, S2, S3, S4) for determining the filling level are provided on or in the first and/or second receiving space G1, G2, and the sensor signals (S1, S2, S3, S4) are used in the calculation of the correction factors (K1, K2) for the pumps (P2, P3).

**8.** Method according to claim 6, **characterised in that** the volume correction $V_{K1}$ of the first receiving space G1 after the next cycle is calculated from the nominal volume, the correction volume of the last cycle $V_{1k-1}$ the calibrated volume $V_{G1}$ and the volume filled by the calibrated filling level.

**9.** Method according to any one of the previous claims, **characterised in that** a characteristic correction of pumps P2 and P3 takes place.

**10.** Method according to any one of the preceding claims, **characterised in that** the correction of the feed volume flow for external feed flows and/or the correction of the bleed volume flow is done by external bleed flows.

11. Method according to any one of the preceding claims, **characterised in that** the correction of the volume flows is done by analysis of the feed and/or bleed substances and/or by analysis of the reprocessed bleed solution.

12. Method according to any one of the preceding claims, **characterised in that** the bleed and feed flows are not synchronous.

13. Device for a bleed and feed process, **characterised in that** the device contains a tank T1, T2 for the respective feed or bleed solution, as well as in each case a receiving space G1, G2 for interim storage of the feed or bleed solution, and a process tank PT as well as pumps P1, P4 for liquid transport between the tank T1, T2 and the receiving space G1, G2, and pumps P2, P3 for liquid transport between the receiving space G1, G2 and the process tank PT, sensors S1, S2, S3 and S4 for determining the filling level in the receiving space G1, G2, valves (V1, V2, V3, V4), as well as a process control computer PR, which controls the flow of the bleed or feed solution out of or into the process tank PT.

14. Method according to claim 13, **characterised in that** several feed systems with several receiving spaces for interim storage of the feed solutions, tanks and pumps, and one or more bleed systems with receiving spaces for interim storage, tanks and pumps are provided.

15. Method according to claim 13 or 14, **characterised in that** the device also includes a system for analysis of the bleed solution.

16. Method according to any one of claims 13 to 15, **characterised in that** the device also includes a system for processing of the bleed solution.

## Revendications

1. Procédé d'exécution d'une opération de soutirage et d'alimentation de solutions de traitement dans une cuve de traitement, dans lequel
   la solution d'alimentation provenant d'une première cuve T1 est pompée dans un premier espace de réception G1 de solution d'alimentation et le premier espace de réception G1 est ensuite vidé dans la cuve de traitement PT au moyen d'une pompe P2, le volume de la quantité de solution d'alimentation apportée dans la cuve de traitement PT étant mesuré,
   la solution de soutirage provenant de la cuve de traitement PT est pompée dans un deuxième espace de réception G2 de solution de soutirage au moyen d'une pompe P3, le volume de la quantité de solution de soutirage transportée depuis la cuve de traitement PT jusque dans le deuxième espace de réception G2 étant mesuré, la solution de soutirage présente dans le deuxième espace de réception G2 étant ensuite vidée dans la deuxième cuve,
   le premier espace de réception G1 étant différent du deuxième espace de réception G2 et un facteur de correction au moyen duquel la quantité de consigne transportée par les pompes P2 et P3 au cours du cycle suivant est corrigée est calculé à partir de la comparaison des volumes mesurés ou calculés de solution soutirée et de solution d'alimentation transportée par les pompes P2 et P3.

2. Procédé selon la revendication 1, **caractérisé en ce que** les espaces de réception G1, G2 sont conçus de telle sorte que l'erreur de détermination des volumes soit inférieure à 0,1 %, de préférence inférieure à 0,05 % et de façon particulièrement préférable inférieure à 0,02 %.

3. Procédé selon l'une des revendications précédentes, **caractérisé en ce que** le débit volumique de solution d'alimentation lors du remplissage du premier espace de réception G1 depuis la cuve T1 représente au moins le double, de préférence au moins 5 fois et de façon particulièrement préférable au moins 20 fois le débit volumique de solution d'alimentation lors du remplissage de la cuve de traitement PT.

4. Procédé selon l'une des revendications précédentes, **caractérisé en ce que** la durée au cours de laquelle la solution d'alimentation est extraite du premier espace de réception G1 au moyen de la pompe P2 pour être envoyée dans la cuve de traitement PT représente un multiple de la durée au cours de laquelle la solution d'alimentation provenant de la première cuve T1 est pompée dans le premier espace de réception G1 et représente en de préférence au moins le double, de préférence 5 fois et de façon particulièrement préférable au moins 20 fois.

**5.** Procédé selon l'une des revendications précédentes, **caractérisé en ce que** le remplissage de la première chambre de réception G1 (ou la vidange de la deuxième chambre de réception G2) par l'intermédiaire de la cuve T1 (ou dans la cuve T2) et la vidange du premier espace de réception G1 (ou le remplissage du deuxième espace de réception G2) dans ou hors de la cuve de traitement PT s'effectuent par le même conduit et **en ce que** lorsque la pompe P2 (ou P3) fonctionne, la pompe P1 (ou P4) est débranchée et lorsque la pompe P1 (ou P4) fonctionne, la pompe P2 (ou P3) est débranchée.

**6.** Procédé selon l'une des revendications 1 à 4, **caractérisé en ce que** le remplissage du premier espace de réception G1 (ou la vidange du deuxième espace de réception G2) par l'intermédiaire de la cuve T1 (ou dans la cuve T2) et la vidange du premier espace de réception G1 (ou le remplissage du deuxième espace de réception G2) dans ou hors de la cuve de traitement PT s'effectuent par des conduits différents, les pompes P2 et P3 n'étant pas débranchées pendant un cycle de soutirage et d'alimentation.

**7.** Procédé selon la revendication 6, **caractérisé en ce que** des sondes (S1, S2, S3, S4) de détermination de la hauteur de remplissage.sont prévues dans le premier et/ou le deuxième espace de réception G1, G2 et **en ce que** les signaux (S1, S2, S3, S4) des sondes interviennent dans le calcul des facteurs de correction (K1, K2) des pompes (P2, P3).

**8.** Procédé selon la revendication 6, **caractérisé en ce que** la correction de volume $V_{k1}$ du premier espace de réception G1 est calculée après le cycle suivant à partir du volume de consigne, du volume de correction du dernier cycle $V_{1k-1}$, du volume étalonné $V_{GJ}$ et du volume rempli au-delà du niveau de remplissage étalonné.

**9.** Procédé selon l'une des revendications précédentes, **caractérisé en ce que** la correction des pompes P2 et P3 s'effectue suivant une ligne caractéristique.

**10.** Procédé selon l'une des revendications précédentes, **caractérisé en ce que** la correction du débit volumique d'alimentation s'effectue pour des écoulements externes d'alimentation et/ou **en ce que** la correction du débit volumique de soutirage s'effectue par des écoulements externes de soutirage.

**11.** Procédé selon l'une des revendications précédentes, **caractérisé en ce que** la correction des débits volumiques s'effectue par analyse des substances d'alimentation et/ou soutirées et/ou par analyse de la solution soutirée repréparée.

**12.** Procédé selon l'une des revendications précédentes, **caractérisé en ce que** les écoulements soutirés et d'alimentation ne sont pas synchrones.

**13.** Dispositif en vue d'exécuter un procédé de soutirage et d'alimentation, **caractérisé en ce que** le dispositif présente des cuves T1, T2 respectivement pour la solution d'alimentation et la solution soutirée, des espaces de réception G1, G2 permettant de conserver temporairement respectivement la solution d'alimentation et la solution soutirée, une cuve de traitement PT, des pompes P1, P4 pour le transport de liquide entre les cuves T1, T2 et les espaces de réception G1, G2 et des pompes P2, P3 qui assurent le transport de liquide entre les espaces de réception G1, G2 et la cuve de traitement PT, des sondes S1, S2, S3, S4 de détermination du niveau de remplissage des espaces de réception G1, G2, des soupapes (V1, V2, V3, V4) ainsi qu'un calculateur de processus PR qui commande le débit de solution soutirée ou de solution d'alimentation depuis ou dans la cuve de traitement PT.

**14.** Dispositif selon la revendication 13, **caractérisé en ce qu'**il présente plusieurs systèmes d'alimentation dotés de plusieurs espaces de réception permettant de conserver temporairement les solutions d'alimentation, de cuves et de pompes ainsi que d'un ou plusieurs systèmes de soutirage dotés d'espaces de réception permettant de conserver temporairement, des cuves et des pompes.

**15.** Dispositif selon les revendications 13 ou 14, **caractérisé en ce que** le dispositif comporte en outre un système d'analyse de la solution soutirée.

**16.** Dispositif selon l'une des revendications 13 à 15, **caractérisé en ce que** le dispositif comporte en outre un système de préparation de la solution soutirée.

Fig. 1

Fig. 2

Fig. 3

Fig. 4

Fig. 5

$$K_1 = V_{G1}/(t_{G1}*Q_{t1})$$
$$V_{k1} = (t_{G1}+t_{iG1})*Q_s+V_{k1-1}-V_{G1}-(Q_{t1}*t_{iG1})$$

$$Q_{k1} = V_{k1}/t_k$$

$$Q_{p2} = Q_t*K_1$$

P2 Kennlinie → P2

$$K_2 = V_{G2}/(t_{G2}*Q_{t2})$$
$$V_{k2} = (t_{G2}+t_{iG2})*Q_s+V_{k2-1}-V_{G2}-(Q_{t2}*t_{iG2})$$

$$Q_{k2} = V_{k2}/t_k$$

$$Q_{p3} = Q_t*K_2$$

P3 Kennlinie → P3

S1 S2

S3 S4

$V_{G1}$  $Q_{t1}$  $Q_s$  $t_k$  $V_{G1}$  $Q_{t2}$  $Q_s$

$Q_{t1}$  $Q_{k1}$  $Q_s$  $Q_{t1}$  $Q_{k2}$  $Q_s$

$V_{k1}$  $K_1$  $V_{k2}$  $K_1$

Fig. 6

17

Fig. 7

Volumen
A,B und C

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20040142566 A1